# EUROPÄISCHE PATENTSCHRIFT

(11) **EP 2 506 437 B1**
(45) Veröffentlichungstag und Bekanntmachung des Hinweises auf die Patenterteilung: **18.05.2016**
(21) Anmeldenummer: 12002229.8
(22) Anmeldetag: 28.03.2012
(51) Int. Cl.: H03K 21/38, G01M 13/02

(54) **Wellenbrucherkennung**
Shaft break detection
Détection de rupture d'un arbre

(30) Priorität: 30.03.2011 DE 102011015581
(43) Veröffentlichungstag der Anmeldung: 03.10.2012
(73) Patentinhaber: Phoenix Contact GmbH & Co. KG, 32825 Blomberg (DE)
(72) Erfinder: Teutenberg, Jürgen, 59602 Rüthen (DE)
(74) Vertreter: Kampfenkel, Klaus

(56) Entgegenhaltungen:
- EP-A1- 0 312 633
- JP-A- S60 109 656
- US-A- 3 877 003

## Beschreibung

Die Erfindung bezieht sich auf ein Verfahren und eine Schaltungsanordnung zur Erkennung des Bruch seines Antriebswellenzuges zwischen Antriebsende und Abtriebsende.

Unter einem Antriebswellenzug ist eine Antriebsmechanik zu verstehen, die ein oder mehrere Einzelwellen, Übersetzungen, Kupplungen und dergleichen aufweist, welche gleichsinnig angetrieben werden. Ein Antriebswellenzug kann irgendwo zwischen Antriebsende und Abtriebsende zu Bruch gehen oder sonst wie ausfallen, weswegen bestrebt wird, einen solchen Wellenbruch automatisch zu erkennen. Zu diesem Zweck werden an beiden Enden des Wellenzuges Sensoren angebracht wie z.B. im Dokument JP 560109656 A beschrieben, mit denen die Bewegung des Wellenzuges festgestellt werden kann. Wenn beide Sensoren die gleichen Messergebnisse liefern, wird fehlerfreier Betrieb erkannt, andernfalls ein Wellenbruch signalisiert.

Bei der Überwachung eines Antriebswellenzuges interessiert nicht nur die Wellenbrucherkennung, sondern auch die Drehrichtung, die Drehgeschwindigkeit und die Winkelposition des Antriebswellenzuges. Deshalb gibt es am Antriebsende eines Wellenzuges einen Sensor mit hoher Messauflösung, der zur Bestimmung dieser Größen benutzt wird. Dieser Sensor hoher Messauflösungen wird gewöhnlich mit einem zweiten Sensor viel geringerer Auflösung am Abtriebsende des Wellenzuges benutzt, um die Wellenbrucherkennung durchzuführen. In technischer Ausführung bedeutet dies die Verwendung eines Incrementalencoders am Antriebsende und eines Initiator am Abtriebsende des Wellenzuges. Die Signalimpulse des Initiators werden in regelmäßigen Zeitabständen erwartet, wenn eine Mindestgeschwindigkeit der Anlage vorliegt. Für die Wellenbrucherkennung werden bei derartigen bekannten Anlagen nur die Signale des ersten Sensors hoher Messauflösung und die Pulserkennung des zweiten Sensors geringerer Messauflösungen herangezogen.

Bei solchen bekannten Anlagen kann es zu Missdeutungen, also Falschaussagen über einen Wellenbruch kommen. Führt der Wellenzug keine kontinuierliche Rotation aus, sondern wechselt ständig die Drehrichtung, so kann es vorkommen, dass ein Wellenbruch fälschlich signalisiert wird, weil die am Abtriebsende ankommende Bewegung keine Impulse des zweiten Sensors auslöst, wenn die Hin- und Her-Drehbewegung in einen impulsfreien Intervall des Sensors am Abtriebsende stattfindet.

In einer anderen Situation wird ein Wellenbruch nicht erkannt, wenn das Abtriebsende trotz Wellenbruches mitgeschleift wird, da der zweite Sensor geringerer Messauflösung gelegentlich Impulse abgibt, die das Vorhandensein eines intakten Antriebswellenzuges vortäuschen.

Schließlich kann auch dann eine Fehlanzeige erzeugt werden, wenn der Wellenzug stillsteht, aber vibriert und die Vibrationen dazu führen können, dass einer der Sensoren Impulse abgibt, die als Drehung des Wellenzuges missdeutet wird, während der andere Sensor Stillstand signalisiert.

Für den Betreiber einer Anlage ist es sehr misslich, wenn die Verfügbarkeit der Anlage durch unzureichende Fehlererkennung gefährdet wird.

Der Erfindung liegt die Aufgabe zugrunde, ein Verfahren der Wellenbrucherkennung anzugeben, das die geschilderten Mißlichkeiten vermeidet. Insbesondere soll eine Schaltungsanordnung zur Erkennung des Bruchs eines Antriebswellenzuges zwischen Antriebsende und Abtriebsende geschaffen werden, welche die Anlageteile zur Bestimmung von Rotationsgeschwindigkeit, Drehwinkelposition und Drehrichtung von Wellenzügen mitbenutzen kann.

Bei der Erfindung werden in Abhängigkeit von Wellenantrieb und Wellenabtrieb Impulszüge erzeugt, die im festen Frequenzverhältnis (U) zueinander stehen. Wellenbruch wird durch Vergleich der Zählstände zweier Zähler erkannt, wovon der erste Zähler durch Impulse des ersten Impulszuges, der zweite Zähler jedoch blockweise, gemäß festem Frequenzverhältnis (U), weitergeschaltet wird. Wellenbruch liegt vor, wenn der Vergleich der Zählerstände ein Missverhältnis zeigt, d. h. wenn die Vergleichszahl außerhalb eines Wertebereichs von z. B. 0,5 bis 2 liegt. Wellenbruch liegt auch dann vor, wenn der Zählerstand des zweiten Zählers einen vorgegebenen Absolutwert unterschreitet.

Die Schaltungsanordnung nach der Erfindung enthält einen das Antriebsende abtastenden ersten Sensor hoher Messauflösung und einen zugeordneten Impulsdetektor zur Abgabe eines ersten Impulszuges, sowie einen das Abtriebsende abtastenden zweiten Sensor geringerer Messauflösung und einen zugeordneten Impulsdetektor zur Abgabe eines zweiten Impulszuges. Erste und zweite Zähler werden mit detektierten Impulsen beaufschlagt. Als Besonderheit der Erfindung ist ein fest eingestellter Frequenzverhältnis-Impulsgeber vorgesehen, der Impulse in Abhängigkeit vom Frequenzverhältnis U der Impulse des ersten Sensors zu den Impulsen des zweiten Sensor abgibt, und zwar gemäß einem ungestörten Abtrieb (ohne Wellenbruch). Die Schaltungsanordnung umfasst auch Mittel zur Bildung von Zeitfenstern tₘ für Mess- und Auswertungsperioden sowie Auswertungsmittel zum Vergleich der Zählerstände des ersten und zweiten Zählers sowie zur Abgabe eines Fehlersignals, wenn ein Messverhältnis zwischen den Zählerständen festgestellt wird. Während der erste Zähler von den Impulsen des ersten Impulsdetektors beaufschlagt wird, empfängt der zweite Zähler, gesteuert von den Impulsen des zweiten Impulsdetektors, die Frequenzverhältnis-Impulsanzahl U des Frequenzverhältnis-Impulsgebers. Auswertemittel vergleichen die Zählerstände des ersten und zweiten Zählers und geben ein Fehlersignal ab, wenn ein Missverhältnis zwischen den Zählerständen vorliegt.

Was als Missverhältnis interpretiert wird, hängt davon ab, wie die vom ersten Sensor oder ersten Impulsdetektor erzeugten Impulse im ersten Zähler im Verhältnis zu der Frequenzverhältnis-Impulsanzahl U des Frequenzverhältnis-Impulsgebers im zweiten Zähler aufsummiert werden. Der erste Sensor hoher Messauflösung erzeugt eine rasche Impulsfolge im Verhältnis zu dem zweiten Sensor, und wenn der erste Impulsdetektor diese rasche Impulsfolge in kurzen Zeitabständen oder fortlaufend weitergibt, wächst der Zählerstand im ersten Zähler rasch an, während der Zählerstand im zweiten Zähler an sich nur gelegentlich des Eintreffens eines Impulses vom zweiten Impulsdetektor, dann jedoch um das Maß U des Frequenzverhältnisses zwischen Antrieb und Abtrieb anwächst. Bei ungestörter Rotation in einer Drehrichtung ergeben sich Zählerstände in gleicher Größenordnung in beiden Zählern, und dies wird in den Auswertemitteln als "fehlerfrei" bewertet.

Wenn jedoch vom zweiten Impulsdetektor keine, oder nur spärliche Impulse eintreffen, weil ein Wellenbruch vorliegt, wird der Zählerstand im zweiten Zähler gegenüber dem Zählerstand im ersten Zähler stark nachhinken, und dies wird als Bruch im Antriebswellenzug bewertet.

Wenn der Wellenzug still steht, aber etwas vibriert, können spärliche Impulse erzeugt werden, was aber die Zählerstände pro Zeitfenster tₘ absolut niedrig anwachsen lässt. Dies wird als "kein Wellenbruch" bewertet.

Wenn am Antriebsende ständig die Drehrichtung sich innerhalb weniger Winkelgrade ändert und dies in einem impulsfreien Intervall des Sensors am Abtriebsende stattfindet, dann wächst der Zählstand im ersten Zähler während eines Zeitfensters tₘ nur absolut niedrig an, und dies wird als "kein Wellenbruch" bewertet.

Als Wellenbruch kann noch folgendes Kriterium herangezogen werden: Wenn einer der Zähler einen Mindestwert überschreitet, dann muss auch der andere Zähler einen Mindestwert aufweisen, d. h. das Verhältnis der Zählerstände darf einen vorgegebenen Wert nicht überschreiten oder unterschreiten. Wenn dies der Fall ist, wird Wellenbruch signalisiert.

Wenn die Schaltungsanordnung zur Erkennung eines Wellenbruches Teil einer Schaltungsanordnung zur Bestimmung der Rotationsgeschwindigkeit, der Winkelposition und der Drehrichtung des Wellenzuges ausgebildet ist, wird der erste Sensor als Incrementalencoder ausgebildet, während als zweiter Sensor auch ein Initiator verwendet werden kann, mit dem lediglich festgestellt wird, ob am Abtriebsende eine Rotation feststellbar ist oder nicht. Ein solcher Incrementalencoder produziert mehrere Signalspuren, aus denen, neben der Rotationsgeschwindigkeit, auch die Winkelposition und die Drehrichtung des Wellenzuges bestimmbar sind. Diese Information kann in den Auswertungsmitteln zur Feststellung des Stillstandes des Wellenzuges und zur Steuerung des ersten Zählers zwecks Kompensation der Vor-Rückwärtsbewegungen des Wellenzuges ausgenutzt werden.

Als Zeitfenster kann ein relativ langer Zeitraum von beispielsweise 2 bis 3 Sekunden gewählt werden. In einem solchen Fall ist es zweckmäßig, Subintervalle innerhalb des Zeitfensters zu bilden, um während dieser Subintervalle Frequenzmessungen an dem ersten Impulszug vorzunehmen und den ersten Zähler entsprechend weiterzuschalten.

Ausführungsbeispiele werden anhand der Zeichnungen erläutert. Dabei zeigt:

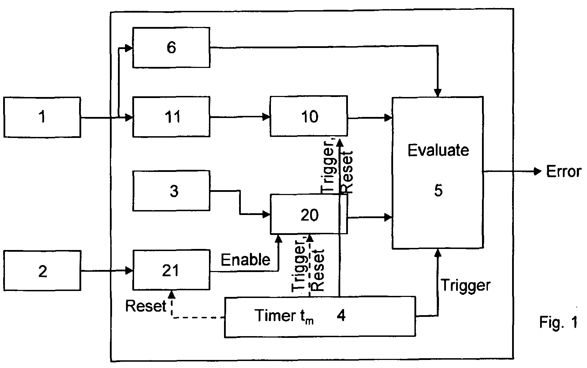

Fig. 1 eine Schaltungsanordnung zur Erkennung des Bruchs eines Antriebswellenzuges, und
Fig. 2 Bewegungssignale eines ersten und eines zweiten Sensors.

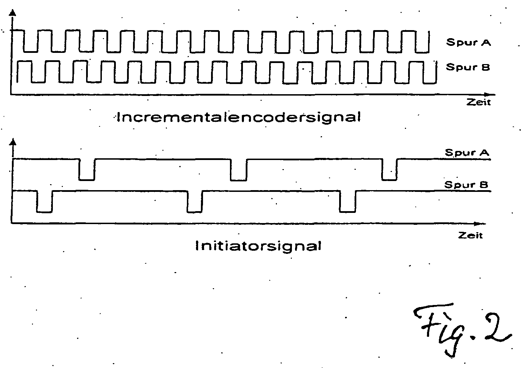

Unter einem Antriebswellenzug werden verschiedene, mechanisch miteinander gekoppelte Bauteile verstanden, denen man ein Antriebsende und ein Abtriebsende zuordnen kann. Am Antriebsende wird ein erster Sensor 1 hoher Messauflösung angeordnet und am Abtriebsende ein zweiter Sensor 2 geringerer Messauflösung. Die entsprechenden Signale sind in Fig. 2 im Prinzip dargestellt. Der Sensor 1 hoher Messauflösung kann ein Initiator sein, bevorzugt wird jedoch ein Incrementalencoder mit mehreren Signalspuren, beispielsweise vier Signalspuren, die zur Bestimmung der Rotationsgeschwindigkeit, der Winkelposition und der Drehrichtung des Wellenzuges dienlich sind. Für den Sensor 2, der zur Feststellung von Rotation am Abtriebsende dient, genügt normalerweise ein Initiator geringerer Messauflösung. Je nach Ausführung mit ein oder zwei Signalspuren werden ein oder zwei Initiatoren verwendet.

Der Verarbeitungsteil der Schaltungsanordnung zur Wellenbrucherkennung kann computermäßig aufgebaut werden, was durch ein Kästchen um diesen Teil herum angedeutet ist. An den ersten Sensor 1 ist ein erster Impulsdetektor 11 angeschlossen, der aufgrund der Sensorsignale einen ersten Impulszug abgibt. Dabei werden Vor- und Rückwärtsbewegungen am Antriebsende innerhalb von Subintervallen berücksichtigt, d. h. entsprechende Signalwerte des Sensors 1 voneinander abgezogen. Dieser erste Impulszug kann als mit der Drehgeschwindigkeit gekoppeltes kompensiertes Frequenzmaß interpretiert werden. An den Sensor 2 ist ein zweiter Impulsdetektor 21 angeschlossen, um den zweiten Impulszug zur Verfügung zu stellen. Zwischen dem ersten und zweiten Impulszug gibt es ein festes Impulsverhältnis, wenn der Antriebswellenzug unversehrt ist, d. h. kein Wellenbruch vorliegt. Dieses feste Verhältnis der Anzahl der Impulse des ersten Impulszuges zu der Anzahl der Impulse des zweiten Impulszuges bei gleichsinniger Drehung des Wellenzuges wird als Frequenzverhältnis-Impulsanzahl U bezeichnet. In der Schaltung ist ein Frequenzverhältnis-Impulsgeber 3 vorgesehen, der zur Abgabe einer Impulsanzahl entsprechend dem Frequenzverhältnis U eingestellt werden kann.

Dem Impulsdetektor 11 ist ein erster Zähler 10 und dem Impulsgeber 3 ist ein zweiter Zähler 20 nachgeschaltet. Die Schaltung umfasst noch einen Timer 4 als Mittel zur Bildung von Zeitfenstern tₘ und Auswertungsmittel 5 zum Vergleichen der Zählerstände des ersten und zweiten Zählers und Abgabe eines Fehlersignals bei Missverhältnis zwischen den Zählerständen. Die Schaltung kann auch noch Mittel 6 zur Gewinnung von Information über Drehrichtung und Winkelposition aus den Signalspuren des Sensor 1 enthalten.

Der Timer 4 dient dazu, die Zeitfenster tₘ zu bestimmen, während welcher die Zähler 10 und 20 gefüllt werden. Hierzu sind Trigger und Reset-Verbindungen vom Timer 4 zu den Zählern 10 und 20 vorhanden. Der Timer 4 dient auch dazu, die Auswertungsmittel 5 zu aktivieren, um die Zählerstände der Zähler 10 und 20 auszuwerten. Schließlich dient auch der Timer 4 dazu, den zweiten Impulsdetektor 21 rückzusetzen, dessen Aufgabe es ist, beim Eintreffen eines Impulses des zweiten Impulszuges den zweiten Zähler 20 zu öffnen, damit die Frequenzverhältnis-Impulsanzahl U des Frequenzverhältnis-Impulsgebers 3 jeweils in einem Block aufgenommen werden können. Der Zähler 20 wird somit blockweise entsprechend dem Wert U weitergeschaltet.

Es sei ungestörter Betrieb des Wellenzuges bei mittlerer Drehgeschwindigkeit angenommen. Über den Sensor 1 und den Impulsdetektor 11 wird eine hohe Rate an Impulsen in dem ersten Impulszähler 10 aufgenommen, so dass für eine vorgegebene Zeit, beispielsweise ein Subintervall des Zeitfensters tₘ ein bestimmter Zählstand im Zähler 10 aufläuft. Während der Drehung des Wellenzuges gibt auch der zweite Sensor 2 ein Signal ab und der Impulsdetektor 21 öffnet den Zähler 20, so dass die Frequenzverhältnis-Impulsanzahl U des Frequenzverhältnis-Impulsgebers 3 aufgenommen wird. Es sei angenommen, dass bei der mittleren Drehgeschwindigkeit des Wellenzuges noch während der Drehung der Welle, der zweite Impulsdetektor 21 aufgrund eines entsprechenden Signals des zweiten Sensors 2 einen weiteren Impuls abgibt, der eine erneute Ausgabe der Frequenzverhältnis-Impulsanzahl U des Frequenzverhältnis-Impulsgebers 3 veranlasst. Während dieser Zeit ist der erste Zähler 10 weiterhin mit Impulsen gespeist worden. Dies setzt sich so fort, bis nach Ablauf des Zeitfensters tₘ die Impulszählung beendet und die Auswertung der Zählerstände vorgenommen wird. Es kann mit Zählständen der Zähler 10 und 20 in etwa der gleichen Größenordnung gerechnet werden, was die Auswertungsmittel 5 als einen unversehrten Antriebswellenzug bewerten.

Bei einem Wellenbruch liefert der zweite Sensor 2 entweder überhaupt kein Signal (wenn das Abtriebsende stillsteht) oder nur spärliche Signale (wenn das Abtriebsende mitgeschleift wird). Wenn keine Signale des zweiten Sensors 2 vorliegen, kann der zweite Impulsdetektor 21 den Zähler 20 nicht öffnen, so dass keine Impulse des Impulsgebers 3 in den Zähler 20 einlaufen. Der Vergleich der Zählstände der Zähler 10 und 20 ergibt ein starkes Missverhältnis und die Auswertungsmittel 5 geben das Fehlersignal "Wellenbruch" ab.

Wenn ein Wellenbruch vorliegt, der zum Mitschleifen des Abtriebsendes führt, dann kommt gelegentlich ein Signal des zweiten Sensors 2 beim zweiten Impulsdetektor 21 an, der daraufhin den zweiten Zähler 20 von Zeit zu Zeit öffnet, so dass in diesen Impulse in geringer Anzahl einlaufen, als es im Falle eines unversehrten Wellenzuges der Fall ist. Der Fehlbetrag im Zähler 20 führt dazu, dass beim Vergleich des Zählstandes des Zähler 20 zu dem des Zählers 10 ein vorgegebener Wert des Verhältnisses unterschritten wird, was als Missverhältnis und Wellenbruch gewertet wird.

Es kann auch vorkommen dass der Zähler 10 einen zu kleinen Wert aufweist, wenn z. B. das entsprechende Ende des Sensors 1 gebrochen ist. Dann wird dies auch als Wellenbruch interpretiert.

Die Auswertungsmittel 5 können auch derart programmiert sein, dass wenn der Zählstand des zweiten Zählers 20 einen Absolutwert unterschreitet, dies als Auftreten eines Wellenbruchs erkannt wird.

Wenn der Wellenzug stillsteht, werden normalerweise weder durch den ersten noch durch den zweiten Sensor Signale abgegeben. Die Auswertungsmittel 5 sind in der Lage, gegebenenfalls unter Mithilfe der Mittel 6 zur Feststellung von Drehrichtung und Winkelposition, diesen Betriebszustand als unversehrten Wellenzug zu deuten, also kein Fehlersignal abzugeben. Es kann aber vorkommen, dass Erschütterungen und Vibrationen dazu führen, dass der erste oder der zweite Sensor sich um eine Spurflanke hin und herbewegt, was zur Erzeugung von Signalen führen kann. Die Anzahl dieser Signale pro Zeitfenster tₘ ist aber gering, verglichen mit einer ordentlichen Bewegung des Wellenzuges. Wenn also der Zählstand in einem der Zähler 10 und 20 eine Mindestanzahl unterschreitet, dann wird störungsfreier Betrieb signalisiert. (Der ODER-Fall kann ja bei Wellenbruch auftreten). Die gleiche Beurteilung erfolgt, wenn die Mittel 6 keine Bewegung signalisieren.

## Patentansprüche

1. Verfahren zur Erkennung des Bruchs eines Antriebswellenzuges zwischen Antriebsende und Abtriebsende, mit folgenden Schritten:
a) Erzeugen eines ersten Impulszuges beim Antriebsende,
b) Erzeugen eines zweiten Impulszuges beim Abtriebsende, **gekennzeichnet durch**:
c) auf Abruf Bereithalten einer Impulsanzahl gemäß Frequenzverhältnis (U) zwischen erstem und zweitem Impulszug,
d) Aufsummieren der Impulsanzahl des ersten Impulszuges während eines Zeitfensters (tₘ) in einem ersten Zähler (10)
e) blockweises Übernehmen der Frequenzverhältnis-Impulsanzahl (U) während des Zeitfensters (tₘ) in einem zweiten Zähler (20) in Abhängigkeit vom Abruf **durch** den zweiten Impulszug,
f) Vergleich der Zählerstände des ersten und zweiten Zählers (10, 20) und Abgabe eines Fehlersignals, wenn ein Missverhältnis zwischen den Zählerständen vorliegt.

2. Verfahren nach Anspruch 1, wobei das Missverhältnis als Unterschreiten eines vorgegebenen Wertes des Verhältnisses der Zählerstände definiert ist.

3. Verfahren nach Anspruch 1, wobei das Missverhältnis als Unterschreiten eines Absolutwertes des Zählstandes des ersten oder zweiten Zählers definiert ist.

4. Schaltungsanordnung zur Erkennung des Bruchs eines Antriebswellenzuges zwischen Antriebsende und Abtriebsende, umfassend:
- einen das Antriebsende abtastenden ersten Sensor (1) zur Abgabe eines ersten Bewegungssignals,
- einen das Abtriebsende abtastenden zweiten Sensor (2) zur Abgabe eines zweiten Bewegungssignals,
**dadurch gekennzeichnet dass**:
- der erste Sensor (1) von hoher Messauflösung ist,
- der zweite Sensor (2) von geringerer Messauflösung ist, und dass die Schaltungsanordnung weiterhin aufweist:-einen ersten Impulsdetektor (11), der an den ersten Sensor (1) angeschlossen ist und einen ersten Impulszug abgibt,
- einen zweiten Impulsdetektor (21), der an den zweiten Sensor (2) angeschlossen ist und einen zweiten Impulszug abgibt,
- einen Frequenzverhältnis-Impulsgeber (3) zur Abgabe einer Frequenzverhältnis-Impulsanzahl (U) gemäß Impulsverhältnis zwischen erstem und zweitem Impulszug bei unversehrtem Antriebswellenzug, -
- einen ersten Zähler (10),
- einen zweiten Zähler (20), und
Mittel (4) zur Bildung von Zeitfenstern (tₘ) für Mess- und Auswertungsperioden, wobei der erste Zähler (10) die Impulsanzahl des ersten Impulszuges während eines Zeitfensters (tm) aufsummiert und die Frequenzverhältnis-Impulsanzahl (U) während des Zeitfensters (tm) in den zweiten Zähler (20) in Abhängigkeit von dem Abruf durch den zweiten Impulszug blockweise übernommen wird, und
- Auswertungsmittel (5) zum Vergleichen der Zählerstände des zweiten Zählers (20) und des ersten Zählers (10) und Abgabe eines Fehlersignals, wenn ein Missverhältnis zwischen den Zählerständen vorliegt.

5. Schaltungsanordnung nach Anspruch 4, wobei der erste Sensor (1) als Inkrementalencodersignalgeber zur präzisen Bestimmung der Drehgeschwindigkeit des Antriebswellenzuges und der zweite Sensor (2) als Initiator zur Feststellung von Rotation am Abtriebsende ausgebildet sind.

6. Schaltungsanordnung nach Anspruch 4 oder 5, wobei der erste Sensor (1) mehrere Signalspuren produziert, und Mittel (6) zur Gewinnung von Information über Drehrichtung und Winkelposition aus den Signalspuren vorgesehen sind.

7. Schaltungsanordnung nach Anspruch 6, wobei die Information über Drehrichtung und Winkelposition in den Auswertungsmitteln (5) als Kriterium für aktuellen Antrieb des Antriebswellenzuges ausnutzbar ist.

8. Schaltungsanordnung nach einem der Ansprüche 4 bis 7, wobei Mittel zur Bildung von Subintervallen innerhalb der Zeitfenster (tₘ) vorgesehen sind, um während der Subintervalle Frequenzmessungen an dem ersten Impulszug vorzunehmen, und den ersten Zähler (1) entsprechend weiterzuschalten.

## Claims

1. A method for detecting break of a drive shaft train between drive end and output end, comprising the steps of:
a) generating a first pulse train at the drive end;
b) generating a second pulse train at the output end; **characterized by**:
c) on request, making available a number of pulses according to a frequency ratio (U) between the first and second pulse trains;
d) adding up the number of pulses of the first pulse train during a time window (tₘ) in a first counter (10);
e) adopting, in blocks, the frequency ratio pulse number (U) in a second counter (20) during the time window (tₘ), in response to the request by the second pulse train;
f) comparing the counts of the first and second counters (10, 20) and issuing an error signal if a discrepancy between the counts exists.

2. The method according to claim 1, wherein the discrepancy is defined as the event where a ratio of the counts falls below a predetermined value.

3. The method according to claim 1, wherein the discrepancy is defined as the event where a count of the first or of the second counter falls below an absolute value.

4. A circuit arrangement for detecting break of a drive shaft train between drive end and output end, comprising:
- a first sensor (1) sampling the drive end for providing a first motion signal;
- a second sensor (2) sampling the output end for providing a second motion signal;
**characterized in that**:
- the first sensor (1) has a high measurement resolution;
- the second sensor (2) has a lower measurement resolution;
and that the circuit arrangement further comprises:
- a first pulse detector (11) connected to the first sensor (1) and supplying a first pulse train;
- a second pulse detector (21) connected to the second sensor (2) and supplying a second pulse train;
- a frequency ratio pulse generator (3) for supplying a frequency ratio pulse number (U) according to a pulse ratio between the first and second pulse trains in case of an intact drive shaft train;
- a first counter (10);
- a second counter (20); and
- means (4) for defining time windows (tₘ) for measurement and evaluation periods, wherein the first counter (10) adds up the number of pulses of the first pulse train during a time window (tₘ), and wherein during the time window (tₘ) the frequency ratio pulse number (U) is adopted in blocks in the second counter (20), in response to a request by the second pulse train; and
- evaluating means (5) for comparing the counts of the second counter (20) and the first counter (10) and issuing an error signal if a discrepancy between the counts exists.

5. The circuit arrangement according to claim 4, wherein the first sensor (1) is configured as an incremental encoder signal generator for precisely determining the rotational speed of the drive shaft train, and the second sensor (2) is configured as an initiator for detecting rotation at the output end.

6. The circuit arrangement according to claim 4 or 5, wherein the first sensor (1) produces a plurality of signal traces, and wherein means (6) are provided for deriving information about rotational direction and angular position from the signal traces.

7. The circuit arrangement according to claim 6, wherein the information about rotational direction and angular position is exploitable in the evaluation means (5) as a criterion for the current driving of the drive shaft train.

8. The circuit arrangement according to any of claims 4 to 7, wherein means are provided for defining subintervals within the time windows (tₘ), in order to perform frequency measurements on the first pulse train during the subintervals and to advance the first counter (1) accordingly.

## Revendications

1. Procédé de détection de la rupture d'un train d'arbres d'entraînement entre l'extrémité d'entraînement et l'extrémité de sortie, comprenant les étapes suivantes :
a) la production d'un premier train d'impulsions à l'extrémité d'entraînement,
b) la production d'un deuxième train d'impulsions à l'extrémité de sortie, **caractérisé par** :
c) sur appel, la mise à disposition d'un nombre d'impulsions conformément au rapport de fréquence (U) entre le premier et le deuxième train d'impulsions,
d) l'addition du nombre d'impulsions du premier train d'impulsions pendant un intervalle de temps (tₘ) dans un premier compteur (10)
e) la réception bloc par bloc du nombre d'impulsions de rapport de fréquence (U) pendant l'intervalle de temps (tₘ) dans un deuxième compteur (20) en fonction de l'appel par le deuxième train d'impulsions,
f) la comparaison des indications du premier et du deuxième compteur (10, 20) et la délivrance d'un signal d'erreur, en présence d'un déséquilibre entre les indications des compteurs.

2. Procédé selon la revendication 1, le déséquilibre étant défini comme le fait qu'une valeur prédéfinie du rapport des indications des compteurs n'est pas atteinte.

3. Procédé selon la revendication 1, le déséquilibre étant défini comme le fait qu'une valeur absolue de l'indication du premier ou du deuxième compteur n'est pas atteinte.

4. Circuit permettant de détecter la rupture d'un train d'arbres d'entraînement entre l'extrémité d'entraînement et l'extrémité de sortie, comprenant :
- un premier capteur (1) balayant l'extrémité d'entraînement de manière à délivrer un premier signal de mouvement,
- un deuxième capteur (2) balayant l'extrémité de sortie de manière à délivrer un deuxième signal de mouvement,
**caractérisé en ce que** :
- le premier capteur (1) présente une résolution de mesure élevée,
- le deuxième capteur (2) présente une résolution de mesure moins élevée,
et **en ce que** le circuit comprend en outre :
- un premier détecteur d'impulsions (11), qui est raccordé au premier capteur (1) et délivre un premier train d'impulsions,
- un deuxième détecteur d'impulsions (21), qui est raccordé au deuxième capteur (2) et délivre un deuxième train d'impulsions,
- un générateur d'impulsions de rapport de fréquence (3) permettant de délivrer un nombre d'impulsions (U) de rapport de fréquence conformément au rapport de fréquence entre le premier et le deuxième train d'impulsions lorsque le train d'arbres d'entraînement est intact,
- un premier compteur (10),
- un deuxième compteur (20), et
des moyens (4) permettant de former des intervalles de temps (tₘ) pour les périodes de mesure et d'évaluation, le premier compteur (10) additionnant le nombre d'impulsions du premier train d'impulsions pendant un intervalle de temps (tₘ) et le nombre d'impulsions de rapport de fréquence (U) pendant l'intervalle de temps (tₘ) dans le deuxième compteur (20) étant réceptionné bloc par bloc en fonction de l'appel par le deuxième train d'impulsions, et
- des moyens d'évaluation (5) permettant de comparer les indications du deuxième compteur (20) et du premier compteur (10) et de délivrer un signal d'erreur, en présence d'un déséquilibre entre les indications des compteurs.

5. Circuit selon la revendication 4, le premier capteur (1) étant réalisé sous la forme d'un générateur de signaux à codeur incrémental permettant de déterminer avec précision la vitesse de rotation du train d'arbres d'entraînement et le deuxième capteur (2) étant réalisé sous la forme d'un initiateur permettant de constater la rotation à l'extrémité de sortie.

6. Circuit selon la revendication 4 ou 5, le premier capteur (1) produisant plusieurs pistes de signal, et des moyens (6) permettant d'obtenir une information concernant le sens de rotation et la position angulaire à partir des pistes de signal étant prévus.

7. Circuit selon la revendication 6, l'information concernant le sens de rotation et la position angulaire dans les moyens d'évaluation (5) pouvant être utilisée comme critère pour l'entraînement actuel du train d'arbres d'entraînement.

8. Circuit selon l'une quelconque des revendications 4 à 7, des moyens permettant de former des sous-intervalles pendant l'intervalle de temps (tₘ) étant prévus, afin de procéder à des mesures de fréquence sur le premier train d'impulsions pendant les sous-intervalles, et de basculer sur le premier compteur (1) de manière correspondante.
